# EUROPEAN PATENT APPLICATION

(11) **EP 4 838 165 A1**
(43) Date of publication of application: **11.11.2026**
(21) Application number: 25181334.1
(22) Date of filing: 06.06.2025
(51) Int. Cl.: F28F 1/12, G06F 1/20, H01L 23/367, F28D 21/00, F28D 1/02

(54) **INTEGRATED WATER-COOLED HEAT SINK**

(30) Priority: 06.05.2025 US 202519199742
(71) Applicant: Dongguan Ice Point Intelligent Technology Co., Ltd, Dongguan Guangdong (CN)
(72) Inventor: Zhang, Fengqi, Dongguan (CN)
(74) Representative: Izquierdo Blanco, Maria Alicia

(57) **Abstract**

The invention discloses an integrated water-cooled heat sink, which comprises a first base, a second base integrally formed with the first base, a sealing plate fixedly installed at the bottom of the first base, and a cold water bank. In the invention, a water pump is transversely arranged on one side of cooking fins to reduce the space occupied in the height direction, thereby enabling the miniaturization of the integrated water-cooled heat sink; the cold water bank is directly connected with the second base through an inlet connector and an outlet connector; the direct connection mode is used in the invention to eliminate a hose and an adapter, thereby saving the occupied space, reducing the overall volume of the cold water bank and the second base, and further enabling the miniaturization of the integrated water-cooled heat sink.

## Description

### TECHNICAL FIELD

The invention belongs to the technical field of heat sinks, in particular relates to an integrated water-cooled heat sink.

### BACKGROUND ART

The heat sink in the prior art consists of components such as a cold water bank, cooling fins, and a water pump assembly. The installation method between the cold water bank and the water pump involves connecting the cold water bank adapter to the adapter on the water pump via a hose, forming a connection between the cold water bank and the water pump assembly. However, the arrangement occupies a large amount of space. Meanwhile, the water pump assembly is installed above the cooling fins and takes up considerable space, hindering miniaturization.

### SUMMARY OF THE INVENTION

### (1) Technical problem to be solved

Aiming at the deficiencies of the prior art, the invention aims to provide an integrated water-cooled heat sink, which is designed to solve the problem in the prior art that the heat sink is not conducive to miniaturization.

### (2) Technical proposal

To solve the above technical problems, the invention provides an integrated water-cooled heat sink, which comprises a first base, a second base integrally formed with the first base, a sealing plate fixedly installed at the bottom of the first base, and a cold water bank;

Cooling fins are fixedly installed on the sealing plate, a first cavity for accommodating the cooling fins is provided on one side of the second base, a second cavity is provided on the other side of the second base, a water pump is fixedly installed inside the second cavity, the water pump and the cooling fins are arranged transversely, and the second base is connected to the cold water bank through a connector.

Preferably, the connector comprises an inlet connector and an outlet connector, an inlet channel is arranged on one side of the second base, one end of the inlet connector is fixedly connected to a water outlet of the cold water bank, and the other end of the inlet connector is fixedly connected to the inlet channel.

Further, a mounting groove connected to the second cavity is arranged on the other side of the second base, a circular plate is fixedly installed inside the mounting groove, and an inlet hole is arranged in the middle of the circular plate.

Even further, a cover plate is fixedly installed on the top of the other side of the second base, and a second sealing strip is installed between the cover plate and the second base.

Even further, a U-shaped waterway connected to the first cavity is arranged in one side of the second base, an outlet channel is arranged inside the second base, one end of the outlet channel is connected to the first cavity, the other end of the outlet channel is fixedly connected to one end of the outlet connector, and the other end of the outlet connector is fixedly connected to the water inlet of the cold water bank.

Even further, a connecting waterway connected with the second cavity and the U-shaped waterway is arranged inside the second base.

Even further, a connecting waterway connected to the U-shaped waterway is arranged on the sealing plate.

Even further, a first sealing strip is installed between the sealing plate and the first base.

### Beneficial Effects

Compared with the prior art, the invention has the following beneficial effects:

In the invention, the water pump is transversely arranged on one side of the cooling fins and occupies the idle space in the transverse direction of the chassis. Unlike the conventional mode of arrangement, where the water pump is placed above the cooling fins, the arrangement of the invention reduces the space occupied in the height direction, thereby enabling the miniaturization of the integrated water-cooled heat sink; the cold water bank is directly connected with the second base through the inlet connector and the outlet connector; in the conventional connection mode, the cold water bank adapter is connected to the adapter on the base through the hose; in the invention, direct connection mode is used to eliminate a hose and an adapter, thereby saving the occupied space, reducing the overall volume of the cold water bank and the second base, and further enabling the miniaturization of the integrated water-cooled heat sink.

### BRIEF DESCRIPTION OF THE DRAWINGS

FIG. 1 is the stereogram of the invention.
FIG. 2 is the top view of a second base of the invention.
FIG. 3 is the sectional view at A-A in FIG. 2 of the invention.
FIG. 4 is the sectional view at B-B in FIG. 2 of the invention.
FIG. 5 is the side view of the invention.
FIG. 6 is the sectional view at C-C in FIG. 5 of the invention.
FIG. 7 is the stereogram of a circular plate of the invention.
FIG. 8 is the stereogram of a connecting waterway of the invention.
FIG. 9 is the stereogram of a sealing plate of the invention.
FIG. 10 is the schematic view illustrating the use of the invention.

Reference signs: 1. First base; 2. Second base; 3. Sealing plate; 4. Cold water bank; 5. Cooling fin; 6. Water pump; 7. Connector; 8. Circular plate; 9. Cover plate; 10. Second sealing strip; 11. U-shaped waterway; 12. Outlet channel; 13. Connecting waterway; 14. Interconnecting waterway; 15. First sealing strip; 16. Mainboard; 17. Chassis; 201. Inlet channel; 701. Inlet connector; 702. Outlet connector; 801. Inlet hole.

### DETAILED DESCRIPTION OF THE INVENTION

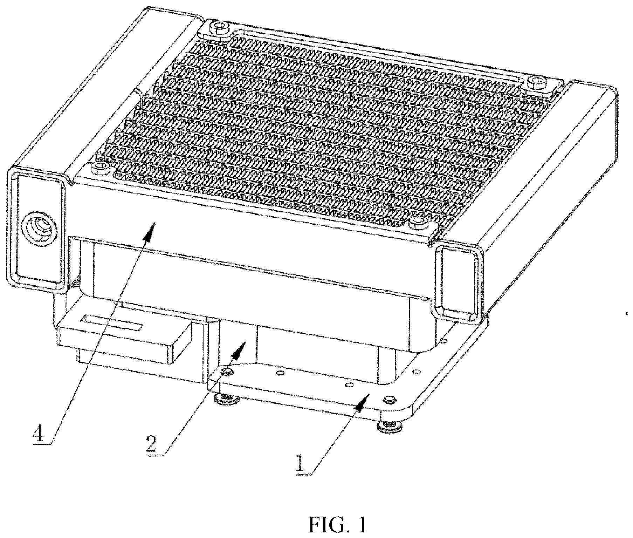

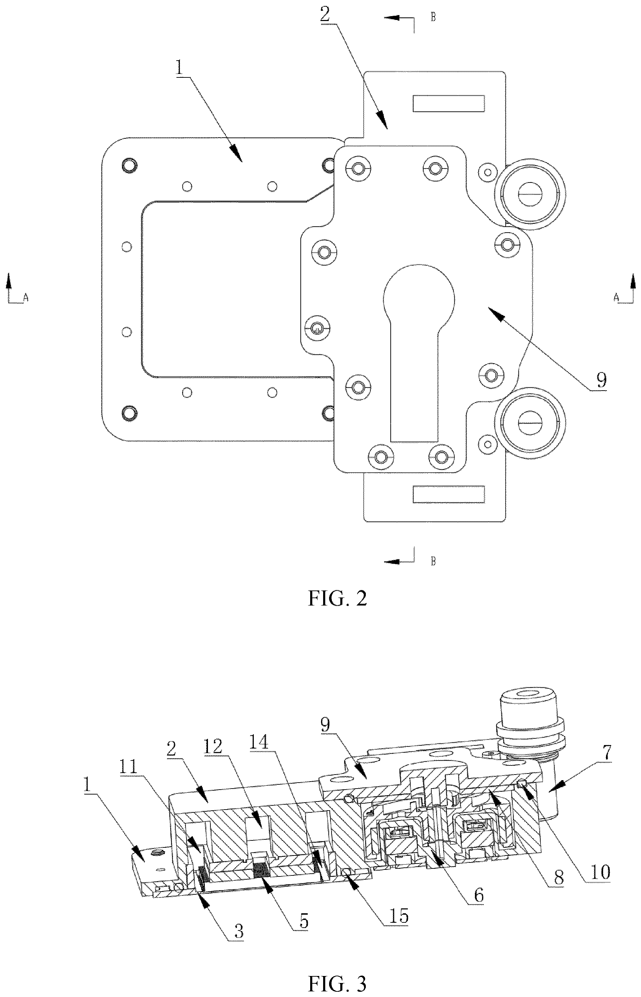

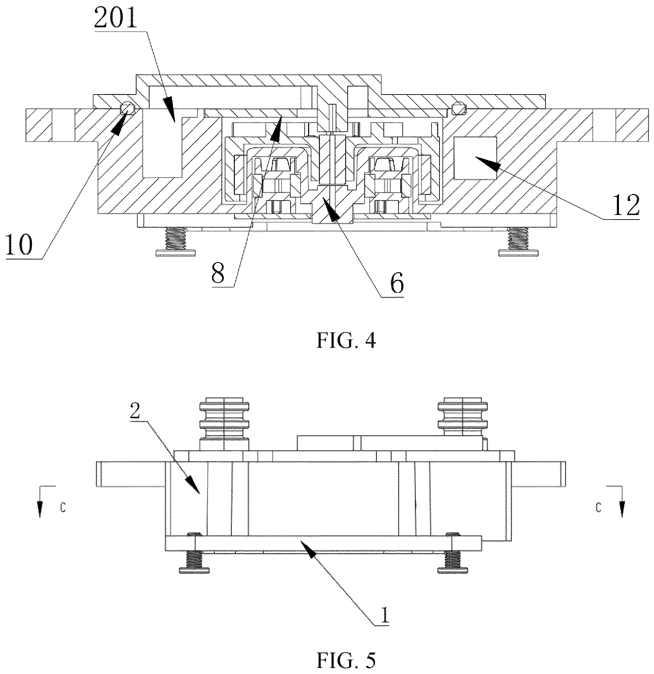

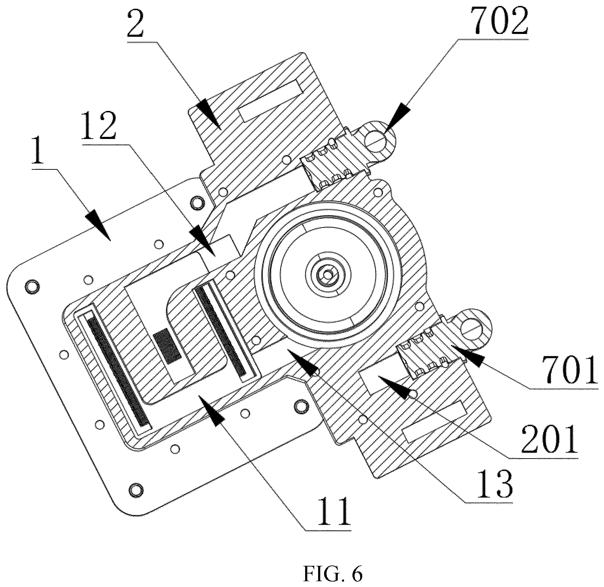

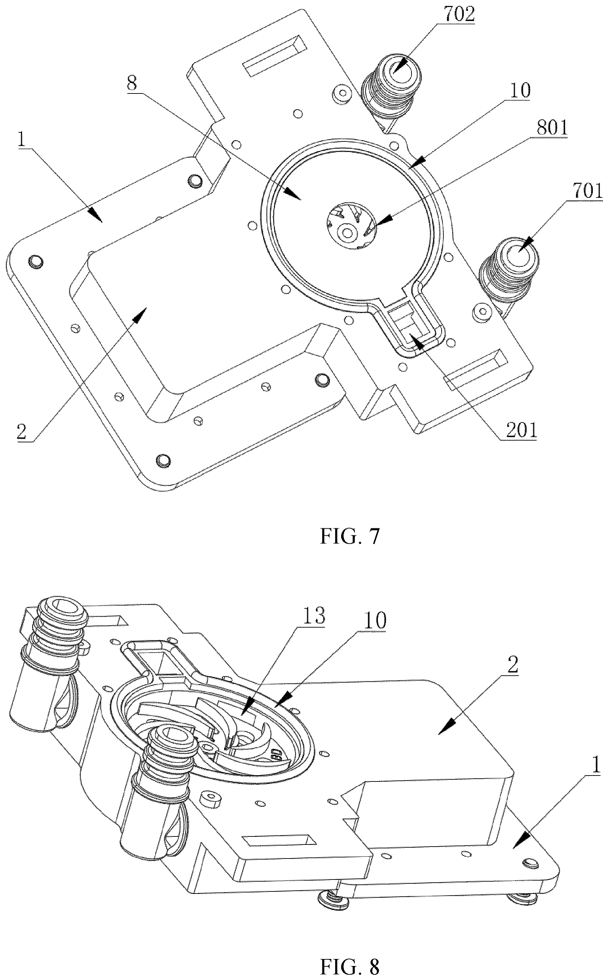

The embodiment provides an integrated water-cooled heat sink, as shown in Fig. 1 to Fig. 10, comprising a first base (1), a second base (2) integrally formed with the first base (1), a sealing plate (3) fixedly installed at the bottom of the first base (1), and a cold water bank (4).

Cooling fins (5) are fixedly installed on the sealing plate (3), a first cavity for accommodating the cooling fins (5) is provided on one side of the second base (2), a second cavity is provided on the other side of the second base (2), a water pump (6) is fixedly installed inside the second cavity, the water pump (6) and the cooling fins (5) are arranged transversely, and the second base (2) is connected to the cold water bank (4) through a connector (7); the water pump (6) and the cooling fins (5) are arranged transversely inside the second base (2), so that the water pump (6) and the cooling fins (5) are similarly at the same height; the water pump (6) is transversely arranged on one side of the cooling fins (5), and occupies the idle transverse space within the chassis (17); compared to the conventional mode of arranging the water pump (6) above the cooling fins (5), the arrangement mode of the invention significantly reduces the vertical space occupation, so that the integrated water-cooled heat sink is miniaturized.

The connector (7) comprises an inlet connector (701) and an outlet connector (702), an inlet channel (201) is arranged on one side of the second base (2), one end of the inlet connector (701) is fixedly connected to a water outlet of the cold water bank (4), and the other end of the inlet connector (701) is fixedly connected to the inlet channel (201); the cold water bank (4) of the invention adopts the conventional structure from the prior art, which is not reiterated herein; the distinction from the prior art lies in the cold water bank (4) is directly connected with the second base (2) via the inlet connector (701) and the outlet connector (702); in contrast, conventional connection requires the cold water bank adapter to connect with the adapter on the base through a hose; the invention adopts direct connection mode to eliminate the hose and one adapter, thereby saving the space, reducing the overall volume of the cold water bank (4) and the second base (2), and further contributing to the miniaturization of the integrated water-cooled heat sink.

A U-shaped waterway (11) connected to the first cavity is arranged in one side of the second base (2), an outlet channel (12) is arranged inside the second base (2), one end of the outlet channel (12) is connected to the first cavity, the other end of the outlet channel (12) is fixedly connected to one end of the outlet connector (702), the other end of the outlet connector (702) is fixedly connected to the water inlet of the cold water bank (4), a connecting waterway (13) connected with the second cavity and the U-shaped waterway (11) is arranged inside the second base (2), a connecting waterway (14) connected to the U-shaped waterway (11) is arranged on the sealing plate (3).

Cold water in the cold water bank (4) flows into the inlet channel (201) through the inlet connector (701), flows to the circular plate (8) through the inlet channel (201) and flows into the second cavity through the inlet hole (801) arranged on the circular plate (8), blades rotate to drive the cold water to flow in the second cavity when the water pump (6) inside the second cavity operates, the flowing cold water flows through the connecting waterway (13) to the U-shaped waterway (11) connected with the first cavity, the cold water in the U-shaped waterway (11) flows through the interconnecting waterway (14) to the cooling fins (5), the cold water exchanges heat with the cooling fins (5), the cold water turns into hot water and then flows through the outlet channel (12) connected to the first cavity after heat exchange, the hot water in the outlet channel (12) flows into the cold water bank (4) through the outlet connector

(702) for cooling, and the cold water cooled flows into inlet channel (201) through the inlet connector (701), forming a continuous cycle to achieve heat dissipation. The cold water bank (4) adopts such cooling mode that a motor inside drives a wind wheel to suck indoor air into the fan blades, water is evaporated into water vapor through a cooling system, the air sucked is cooled by utilizing the heat absorption property of water vapor, and finally the cold air is blown out through an air duct to achieve the cooling effect.

A first sealing strip (15) is installed between the sealing plate (3) and the first base (1), and a groove for installing the first sealing strip (15) is provided at the corresponding position between the sealing plate (3) and the first base (1); under the action of the first sealing strip (15), the waterproof sealing effect can be achieved.

A mounting groove connected to the second cavity is arranged on the other side of the second base (2), a circular plate (8) is fixedly installed inside the mounting groove, and an inlet hole (801) is arranged in the middle of the circular plate (8); a cover plate (9) is fixedly installed on the top of the other side of the second base (2), and a second sealing strip (10) is installed between the cover plate (9) and the second base (2).

A groove for installing the first sealing strip (15) is provided at the corresponding position between the cover plate (9) and the second base (2); under the action of the first sealing strip (15), the waterproof sealing effect can be achieved.

During operation, the blades of the water pump (6) can rotate. The circular plate (8) is arranged, and an extension column inserted into the inlet hole (801) is fixedly installed on the inner top wall of the cover plate (9), thereby preventing the cold water in the second cavity from splashing during the rotation of the blades.

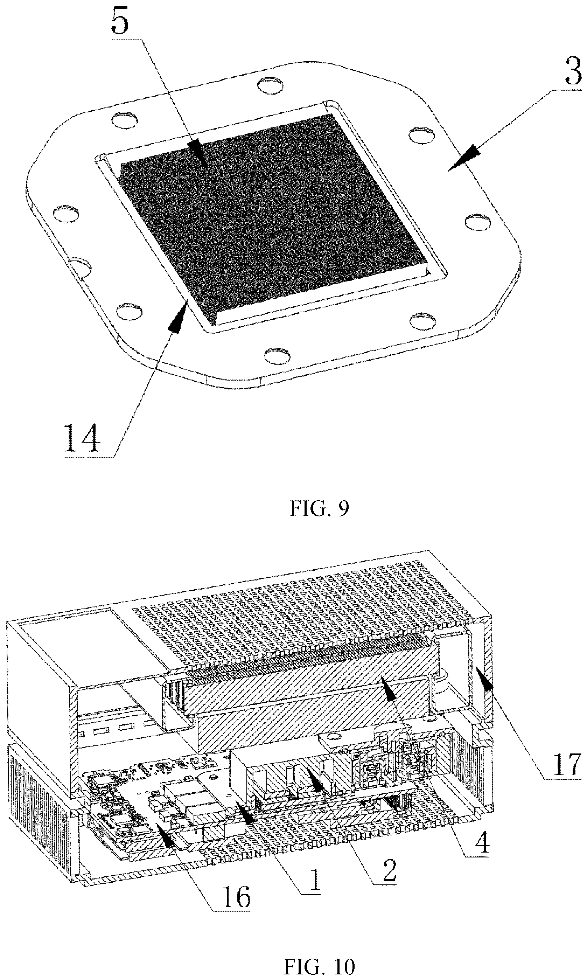

FIG. 10 is the practical schematic diagram of the integrated water-cooled heat sink. The first base (1) is installed on the mainboard (16) through screws and is integrally located inside the chassis (17).

In summary, in the invention, the water pump (6) is transversely arranged on one side of the cooling fins (5) and occupies the idle space in the transverse direction of the chassis (17). Unlike the conventional mode of arrangement, where the water pump (6) is placed above the cooling fins (5), the invention reduces the space occupied in the height direction, thereby enabling the miniaturization of the integrated water-cooled heat sink. The cold water bank (4) is directly connected to the second base (2) through the inlet connector (701) and the outlet connector (702). In the conventional connection mode, the cold water bank adapter is connected to the base adapter through a hose. However, the invention uses direct connection mode to eliminate a hose and an adapter, thereby saving the occupied space, reducing the overall volume of the cold water bank (4) and the second base (2), and further enabling the miniaturization of the integrated water-cooled heat sink.

The above embodiments are preferred embodiments of the invention. However, the invention may also be realized in other ways. Any obvious substitutions made without departing from the conceptual framework of the technical proposal shall fall within the protection scope of the invention.

## Claims

1. An integrated water-cooled heat sink, **characterized by** comprising a first base (1), a second base (2) integrally formed with the first base (1), a sealing plate (3) fixedly installed at the bottom of the first base (1), and a cold water bank (4);
cooling fins (5) are fixedly installed on the sealing plate (3), a first cavity for accommodating the cooling fins (5) is provided on one side of the second base (2), a second cavity is provided on the other side of the second base (2), a water pump (6) is fixedly installed inside the second cavity, the water pump (6) and the cooling fins (5) are arranged transversely, and the second base (2) is connected to the cold water bank (4) through a connector (7).

2. The integrated water-cooled heat sink according to claim 1, **characterized in that** the connector (7) comprises an inlet connector (701) and an outlet connector (702), an inlet channel (201) is arranged on one side of the second base (2), one end of the inlet connector (701) is fixedly connected to a water outlet of the cold water bank (4), and the other end of the inlet connector (701) is fixedly connected to the inlet channel (201).

3. The integrated water-cooled heat sink according to claim 2, **characterized in that** a mounting groove connected to the second cavity is arranged on the other side of the second base (2), a circular plate (8) is fixedly installed inside the mounting groove, and an inlet hole (801) is arranged in the middle of the circular plate (8).

4. The integrated water-cooled heat sink according to claim 3, **characterized in that** a cover plate (9) is fixedly installed on the top of the other side of the second base (2), and a second sealing strip (10) is installed between the cover plate (9) and the second base (2).

5. The integrated water-cooled heat sink according to claim 4, **characterized in that** a U-shaped waterway (11) connected to the first cavity is arranged in one side of the second base (2), an outlet channel (12) is arranged inside the second base (2), one end of the outlet channel (12) is connected to the first cavity, the other end of the outlet channel (12) is fixedly connected to one end of the outlet connector (702), and the other end of the outlet connector (702) is fixedly connected to the water inlet of the cold water bank (4).

6. The integrated water-cooled heat sink according to claim 1, **characterized in that** a connecting waterway (13) connected with the second cavity and the U-shaped waterway (11) is arranged inside the second base (2).

7. The integrated water-cooled heat sink according to claim 1, **characterized in that** an interconnecting waterway (14) connected to the U-shaped waterway (11) is arranged on the sealing plate (3).

8. The integrated water-cooled heat sink according to claim 1, **characterized in that** a first sealing strip (15) is installed between the sealing plate (3) and the first base (1).

## Amended claims

### Amended claims in accordance with Rule 137(2) EPC.

1. An integrated water-cooled heat sink, comprising:
a first base (1),
a second base (2) integrally formed with the first base (1), the second base (2) including an inlet channel (201) arranged on one side thereof,
a sealing plate (3) fixedly installed at the bottom of the first base (1),
a cold water bank (4),
a plurality of cooling fins (5) fixedly installed on the sealing plate (3) wherein a first cavity for accommodating the cooling fins (5) is provided on one side of the second base (2), and a second cavity is provided on the other side of the second base (2),
a water pump (6) fixedly installed inside the second cavity wherein the water pump (6) and the cooling fins (5) are arranged transversely,
a connector (7) including an inlet connector (701) and an outlet connector (702) wherein one end of the inlet connector (701) is fixedly connected to a water outlet of the cold water bank (4), and the other end of the inlet connector (701) is fixedly connected to the inlet channel (201), and wherein the second base (2) is connected to the cold water bank (4) through the connector (7),
a mounting groove connected to the second cavity and arranged on the other side of the second base (2), and
a circular plate (8) fixedly installed inside the mounting groove, and an inlet hole (801) arranged in the middle of the circular plate (8).

2. The integrated water-cooled heat sink according to claim 1, further comprising a cover plate (9) fixedly installed on the top of the other side of the second base (2), and a first sealing strip (10) installed between the cover plate (9) and the second base (2).

3. The integrated water-cooled heat sink according to claim 1, further comprising a U-shaped waterway (11) connected to the first cavity and arranged in one side of the second base (2), and an outlet channel (12) arranged inside the second base (2), the outlet channel (12) having one end connected to the first cavity and the other end fixedly connected to one end of the outlet connector (702), and wherein the other end of the outlet connector (702) is fixedly connected to the water inlet of the cold water bank (4).
